# EUROPÄISCHE PATENTSCHRIFT

(11) **EP 4 372 391 B1**
(45) Veröffentlichungstag und Bekanntmachung des Hinweises auf die Patenterteilung: **05.11.2025**
(21) Anmeldenummer: 23197924.6
(22) Anmeldetag: 18.09.2023
(51) Int. Cl.: G01R 21/133, G01R 22/00, H01R 13/66

(54) **MESSENDE STECKDOSE SOWIE NETZWERK VON ELEKTRISCHEN/ELEKTRONISCHEN INSTALLATIONSGERÄTEN**
MEASURING OUTLET AND NETWORK OF ELECTRICAL/ELECTRONIC INSTALLATION DEVICES
PRISE DE MESURE ET RÉSEAU D'APPAREILS D'INSTALLATION ÉLECTRIQUES/ÉLECTRONIQUES

(30) Priorität: 15.11.2022 DE 102022130136; 15.11.2022 DE 202022106389 U
(43) Veröffentlichungstag der Anmeldung: 22.05.2024
(73) Patentinhaber: Insta GmbH, 58509 Lüdenscheid (DE)
(72) Erfinder: Becker-Hennecke, Ralph, 58239 Schwerte (DE)
(74) Vertreter: Fobbe, Tobias

(56) Entgegenhaltungen:
- EP-B1- 2 527 849
- CN-U- 210 377 077
- US-A1- 2015 280 410
- SCHNEIDER ELECTRIC GMBH: "Installationsanleitung Connected SCHUKO-Steckdose 16A", 1 August 2021 (2021-08-01), Website of Schneider Electric GmbH c/o Merten, pages 1 - 2, XP093134460, Retrieved from the Internet <URL:https://www.productinfo.schneider-electric.com/wiser_home/sysm_sysd-connected-single-socket-outlet-16-a-wiser_home_device-user-guide/German/SysM_SysD%20-%20Connected%20Single%20Socket%20Outlet%2016%20A_Wiser_Home_Device%20User%20Guide_de_0000783406.xml/$/WHM-Connectedsinglesocketoutlet16A-Installing>

## Beschreibung

Die Erfindung betrifft eine messende Steckdose zur Energie- und/oder Leistungsmessung bezüglich einer an die Steckdose angeschlossenen Last, umfassend jeweils mindestens zwei Anschlussmittel für einen Außenleiter, einen Neutralleiter und einen Schutzleiter, die an einen Außenleiterkontakt, den Neutralleiterkontakt und den Schutzleiterkontakt der Steckdose angeschlossen sind, sowie ferner umfassend eine Energie- und/oder Leistungsmessungseinrichtung, sowie eine Sendeeinheit zum Übersenden der durch die Energie- und/oder Leistungsmessung erhaltenen Daten an eine Auswerteeinheit.

Ferner betrifft die Erfindung ein Netzwerk von elektrischen/elektronischen Installationsgeräten umfassend eine solche messende Steckdose.

Aus dem Stand der Technik sind verschiedene Verfahren und Vorrichtungen bekannt, welche eine Leistungserfassung einzelner Verbraucher oder einer gesamten Wohneinheit ermöglichen.

US 2009/0195349 A1 offenbart ein System und ein Verfahren zum Überwachen des Energieverbrauchs von Heimanwendungen. Hierzu sind in den einzelnen Steckdosen, in Mehrfachsteckdosen oder in den einzelnen Verbrauchern Messmittel angeordnet, welche den Energieverbrauch der angeschlossenen Verbraucher oder des Verbrauchers direkt ermitteln und an eine zentrale Basiseinheit übermitteln. Basierend auf diesen gemessenen Daten der Verbraucher kann der Energieverbrauch dargestellt werden. Es ist jedoch nachteilig, dass jeder Verbraucher selbst ein Messmittel aufweisen oder an einer Steckdose mit einem entsprechenden Messmittel angeschlossen werden muss. Falls ein Verbraucher direkt ohne ein entsprechendes Messmittel angeschlossen wird, kann sein Energieverbrauch nicht ermittelt und berücksichtigt werden. Zudem muss jedes Messmittel individuell adressierbar sein, um entsprechend im System erkannt und angesprochen zu werden.

US 2015/0280410 A1 beschreibt eine Vorrichtung zum Befestigen eines Verdrahtungsgeräts, das eine Wechselstromsteckdose, einen Schalter, ein Relais, ein hybrides Schalter-Relais und einen hybriden Schalter umfasst, in einer Trägerdose unter Verwendung eines Rastmechanismus. Die Dose enthält intelligente Steuer- und Kommunikationsschaltungen für die Übermittlung von Befehlen und die Steuerung, einschließlich der Meldung des Stromverbrauchs von jeder Steckdose und jedem Gerät.

Aus EP 2 527 849 B1 ist eine Steckdosenleiste bekannt, die eine elektrische Leistungsmessung der einzelnen an die Steckdosenleiste angeschlossenen Geräte ermöglicht, selbst wenn deren Stromverbrauch klein ist.

CN 210 377 077 U beschreibt eine Steuerschaltung, die mit einem Lastkreis gekoppelt ist und ein Leistungsmessmodul, eine Steuermodul und ein Stromversorgungsmodul umfasst. Dabei wird nur ein Leistungsmessmodul verwendet, um die Leistungsnutzungsparameter von dem Lastkreis zu messen.

Messende Steckdosen, die sowohl eine Energie- als auch eine Leistungsmessung über eine Energie- und oder Leistungsmessungseinrichtung ermöglichen, sind kürzlich ebenfalls bekannt geworden: *www.jung-group.com*/*de-DE*/*JUNG-HOME-SCHUKO-Steckdose-Energy-Safety-alpinweiss*/*BT-LS-1521-SE-WW und www.merten.de*/*porodukt*/*meg2380-0319-connected-schuko-steckdose-16a-system-m-thermoplast-brillant-polarwiss-glaenzend.htm*/*#tabspecifications.* Solche Steckdose erlauben es zudem, angeschlossene Verbraucher zu schalten und die erfassten Energie- und oder Leistungsmessung an eine zentrale Auswerteeinheit zu übersenden, so dass eine Auswertung und Visulisierung hinsichtlich der Energie- und oder Leistungsdaten möglich wird. Problematisch bei derartigen Steckdosen ist jedoch, dass die Energie- und/oder Leistungsmessung nur für die Last möglich ist, die an die messende Steckdose angeschlossen ist. Insbesondere erlaubt eine solche messende Steckdose keine Auswertung einer benachbarten, ebenfalls an den Lastkreis der messenden Steckdose, nicht messenden Steckdose, obwohl die benachbarte Steckdose über eine Brücke, realisiert über ein Anschlussmittel für einen Außenleiter, einen Neutralleiter und einen Schutzleiter, vor der Energie- und oder Leistungsmessungseinrichtung, an denselben Lastkreis angeschlossen ist. Vielmehr ist der kostspielige Verbau einer weiteren messenden Steckdose oder einer anderen, zusätzlichen Bauraum beanspruchenden, Messeinheit vorzusehen.

Ausgehend von diesem diskutierten Stand der Technik liegt der Erfindung die Aufgabe zugrunde, eine messende Steckdose zur Energie- und/oder Leistungsmessung bezüglich einer an die Steckdose angeschlossenen Last zu schaffen, die es erlaubt, weitere elektrische Verbraucher, insbesondere Steckdosen, Leuchten oder Jalousieaktoren, die an denselben Lastkreis angeschlossen sind, bezüglich der Energie- und/oder Leistungsaufnahme zu erfassen, ohne eine weitere messende Steckdose zur Energie- und/oder Leistungsmessung mit einer entsprechenden Energie- und oder Leistungsmessungseinrichtung an die Steckdose anzuschließen.

Gelöst wird diese Aufgabe durch eine messende Steckdose, wobei das Anschlussmittel für einen Außenleiter den Außenleiter zur Bildung einer Messbrücke nach der Energie- und/ oder Leistungsmessungseinrichtung kontaktiert, so dass die Energie- und/ oder Leistungsmessungseinrichtung über die Messbrücke weitere an die messende Steckdose angeschlossene Lasten desselben Lastkreises hinsichtlich der Energie- und/oder Leistungsmessung erfassbar macht.

Der Kerngedanke der Erfindung besteht darin, dass durch eine intelligente Kontaktierung des Außenleiters eine Messbrücke geschaffen wird, die über die Energie- und oder Leistungsmessungseinrichtung dank der Messbrücke weitere an die messende Steckdose angeschlossene Lasten desselben Lastkreises hinsichtlich der Energie- und/oder Leistungsmessung erfassbar macht. Hierzu ist bei der erfindungsgemäßen messenden Steckdose zur Bildung einer Messbrücke ein Anschlussmittel für einen Außenleiter vorgesehen, wobei das Anschlussmittel, beispielsweise eine Steckklemme in der Steckdose, den Außenleiter zur Bildung einer Messbrücke nach der Energie- und/ oder Leistungsmessungseinrichtung kontaktiert.

Die im Vergleich zum Stand der Technik nicht intuitive und aufwendigere Kontaktierung des Außenleiters nach der Energie- und/ oder Leistungsmessungseinrichtung wird dabei erfindungsgemäß bewusst in Kauf genommen, um die erfindungsgemäßen Vorteile entgegen der Lehre zu vorbekannten messenden Steckdosen zu erreichen. Dieses umfasst auch das Vorsehen eines dritten Anschlussmittels, beispielsweise einer Steckklemme, für einen Außenleiter an der Steckdose, wobei im Stand der Technik regelmäßig zwei Anschlussmittel je Leiter (also sechs insgesamt, da jeweils zwei für den Außenleiter, den Neutralleiter und den Schutzleiter) vorgesehen werden.

Grundsätzlich umfasst eine solche messende Steckdose zur Energie- und/oder Leistungsmessung bezüglich einer an die Steckdose angeschlossenen Last, jeweils mindestens zwei Anschlussmittel für einen Außenleiter, einen Neutralleiter und einen Schutzleiter, die an einen Außenleiterkontakt, den Neutralleiterkontakt und den Schutzleiterkontakt der Steckdose angeschlossen sind. Die jeweils zwei Anschlussmittel sind daher vorzusehen, da ein Anschlussmittel als Eingang und das andere als Ausgang dient.

Damit eine solche messende Steckdose eine Energie- und/oder Leistungsmessung vornehmen kann, umfasst sie ferner eine Energie- und/ oder Leistungsmessungseinrichtung. Zur Ermöglichung der Auswertung der erfassten Energie- und/oder Leistungsdaten in einer Auswerteeinheit, umfasst die messende Steckdose eine Sendeeinheit zum Übersenden der durch die Energie- und/oder Leistungsmessung erhaltenen Daten an die Auswerteeinheit.

Besonders vorteilhaft bei der erfindungsgemäßen messenden Steckdose ist, dass die Kontaktierung des Außenleiters zur Messung der Energie- und/oder Leistungsmessungsaufnahme nicht wie beim Stand der Technik vor, sondern nach der Energie- und/oder Leistungsmessungseinrichtung erfolgt. Auf diese Art wird die im Stand der Technik ohnehin regelmäßig vorgesehene Bildung einer Brücke zur Energieversorgung eines weiteren elektrischen/elektronischen Installationsgerätes des Lastkreises durch Änderung der Kontaktierungsposition des Außenleiters zur Bildung einer Messbrücke weiterentwickelt. Besonders vorteilhaft dabei ist, dass die bereits im Lastkreis befindliche Verkabelung vollständig erhalten bleibt und es sich für den Anwender überhaupt keine Abweichungen ergeben. Vielmehr wird die vorhandene Brücke in eine Messbrücke umgewandelt, indemdie erfindungsgemäße messende Steckdose statt einer vorbekannten messenden Steckdose genutzt wird. Neben der Ermöglichung weiterer über die Messbrücke an die messende Steckdose angeschlossene Lasten desselben Lastkreises hinsichtlich der Energie- und/oder Leistungsmessung stellt der Erhalt der existierenden Verkabelung einen spürbaren Vorteil da, der die Installationshürde der erfindungsgemäßen messenden Steckdose nicht anhebt - jedoch weitere Messfunktionalitäten ermöglicht und den Verbau weiterer messenden Steckdosen und damit erheblicher Zusatzaufwand und signifikante Zusatzkosten vermeidet.

Gemäß der Erfindung ist
das, die Messbrücke umfassende, Anschlussmittel als drittes Anschlussmittel für den Außenleiter ausgeführt. Damit weist die erfindungsgemäße messende Steckdose drei Anschlussmittel für den Ausleiter und jeweils zwei für den Neutral- beziehungsweise Schutzleiter auf.

Gemäß einer besonders bevorzugten Weiterbildung der erfindungsgemäßen messenden Steckdose umfasst diese ein einkanaliges, ein Schaltelement aufweisendes, Relais. Hierdurch kann vorteilhafterweise zusätzlich zu der eigentlichen Messfunktionalität auch eine Schaltfunktionalität implementiert werden. Aufgrund der Steuerbarkeit über eine Fernbedienung ergibt sich für beide Funktionalitäten ein besonderer Bedienkomfort.

In einer alternativen besonders bevorzugten Weiterbildung der erfindungsgemäßen messenden Steckdose umfasst diese ein zweikanaliges, zwei Schaltelemente aufweisendes, Relais, welches über eine Fernbedienung steuerbar ist. Dabei ist ein Schaltelement in den die Messbrücke realisierenden Außenleiter integriert, so dass auch über die Messbrücke weitere an die messende Steckdose angeschlossene Lasten desselben Lastkreises schaltbar gemacht werden. Insofern kann sowohl die an die messende Steckdose angeschlossene Last als auch weitere an die messende Steckdose angeschlossene Lasten desselben Lastkreises geschaltet werden. Damit wird der durch die Erfindung erreichte Vorteil von der Messfunktionalität zur Energie- und/oder Leistungsmessung vorteilhafterweise auf das Schalten von Lasten desselben Lastkreises erweitert.

Gemäß einer besonders bevorzugten Weiterbildung der erfindungsgemäßen messenden Steckdose ist die Energie- und/oder Leistungsmessungseinrichtung als mehrkanalige, insbesondere zweikanalige, Energie- und/oder Leistungsmessungseinrichtung ausgeführt. Hierdurch werden auf vorteilhafte Weise weitere an die messende Steckdose angeschlossenen Lasten desselben Lastkreises hinsichtlich der Energie- und/oder Leistungsmessung getrennt erfassbar gemacht. Damit wird die Auswertung der Energie- und/oder Leistungsmessung weiter individualisiert, ohne weitere messende Steckdosen vorsehen zu müssen.

In einer Weiterbildung der erfindungsgemäßen messenden Steckdose sind die Anschlussmittel als Steckklemmen ausgeführt. Hierdurch ist eine einfache Handhabung sowie eine zuverlässige Kontaktierung sichergestellt.

Gemäß einer Weiterbildung der erfindungsgemäßen messenden Steckdose weist diese ein Betätigungselement zur Vor-Ort-Betätigung auf, durch das die Energie- und/oder Leistungsmessungseinrichtung und/oder ein Relais gesteuert, insbesondere ein- oder ausgeschaltet, werden kann.

Ferner betrifft die Erfindung ein Netzwerk von elektrischen/elektronischen Installationsgeräten umfassend mindestens ein elektrisches/elektronisches Installationsgerät, insbesondere einen Lichtschalter, einen Jalousieschalter oder eine Steckdose, wobei das Netzwerk ferner eine erfindungsgemäße messende Steckdose umfasst, wobei das mindestens eine elektrische/elektronische Installationsgerät und die messende Steckdose an einen Lastkreis angeschlossen und über die Messbrücke miteinander verbunden sind, so dass die Energie- und/oder Leistungsmessung des Lastkreises ermöglicht wird.

Damit ergeben sich für das erfindungsgemäße Netzwerk dieselben Vorteile wie für die erfindungsgemäße messende Steckdose.

Nachfolgend ist die Erfindung unter Bezugnahme auf die beigefügten Figuren anhand diverser Ausführungsbeispiele beschrieben. Es zeigen:
- **Fig. 1:**: eine schematische Darstellung einer vorbekannten messenden Steckdose, die an einen Lastkreis mit einer nicht messenden Steckdose angeschlossen ist,
- **Fig. 2:**: eine schematische Darstellung von zwei vorbekannten messenden Steckdosen, die an einen Lastkreis angeschlossen sind,
- **Fig. 3:**: eine schematische Darstellung einer erfindungsgemäßen messenden Steckdose,
- **Fig. 4:**: eine schematische Darstellung einer erfindungsgemäßen messenden Steckdose, die über einen Außenleiter zur Bildung einer Messbrücke an zwei weitere nicht messende Steckdosen desselben Lastkreises angeschlossen ist, wodurch ein erfindungsgemäßes Netzwerk von elektrischen/elektronischen Installationsgeräten realisiert wird,
- **Fig. 5:**: eine schematische Darstellung einer erfindungsgemäßen messenden Steckdose mit einem zweikanaligen Relais und
- **Fig. 6:**: eine schematische Darstellung einer erfindungsgemäßen messenden Steckdose mit einer zweikanaligen Leistungsmessungseinrichtung.

In den verschiedenen Figuren sind gleiche Teile stets mit den Gleichen Bezugszeichen versehen und werden daher in der Regel auch jeweils nur einmal benannt beziehungsweise erwähnt.

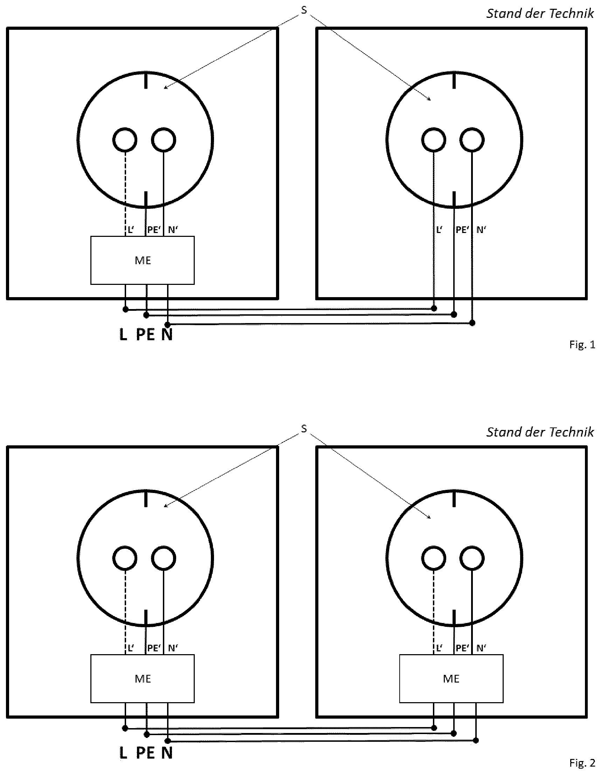

Figur 1 zeigt eine schematische Darstellung einer vorbekannten messenden Steckdose S, die an einen Lastkreis mit einer nicht messenden Steckdose S angeschlossen ist. Der Außenleiter L, der Neutralleiter N und der Schutzleiter PE liegen in der Wand des betreffenden Gebäudes beziehungsweise in der Installationsdose und kontaktieren entsprechende Anschlussmittel der messenden Steckdose S, so dass sie zu den entsprechenden Kontakten der Steckdose S führen, hier: dem Außenleiterkontakt, dem Neutralleiterkontakt und dem Schutzleiterkontakt (regelmäßig als Erdungsbügel ausgeführt). Dabei weist eine solche vorbekannte messende Steckdose S eine Energie- und/oder Leistungsmessungseinrichtung ME auf. Erkennbar dabei ist, dass die von der messenden abgehenden Anschlussmittel für einen Außenleiter L, einen Neutralleiter N und einen Schutzleiter PE vor der Energie- und/oder Leistungsmessungseinrichtung ME angeschlossen sind. Damit ist die Energie- und/oder Leistungsmessung strikt auf eine messende Steckdose S limitiert, obwohl - wie in Figur 1 beispielhaft dargestellt - derselbe Lastkreis noch eine weitere, nicht messende Steckdose S aufweist.

Als Lösung des Problems wird im Stand der Technik regelmäßig eine weitere messende Steckdose S verbaut, wie in Figur 2, eine schematische Darstellung von zwei vorbekannten messenden Steckdosen S, die an einen Lastkreis angeschlossen sind, gezeigt ist. Diese Lösung erfordert jedoch einen erheblichen zusätzlichen Kostenaufwand, da der Preis für eine messende Steckdose S bezüglich einer nicht messenden Steckdose regelmäßig eine Größenordnung auseinanderliegt, was im Wesentlichen in den Kosten der Energie- und/oder Leistungsmessungseinrichtung begründet liegt.

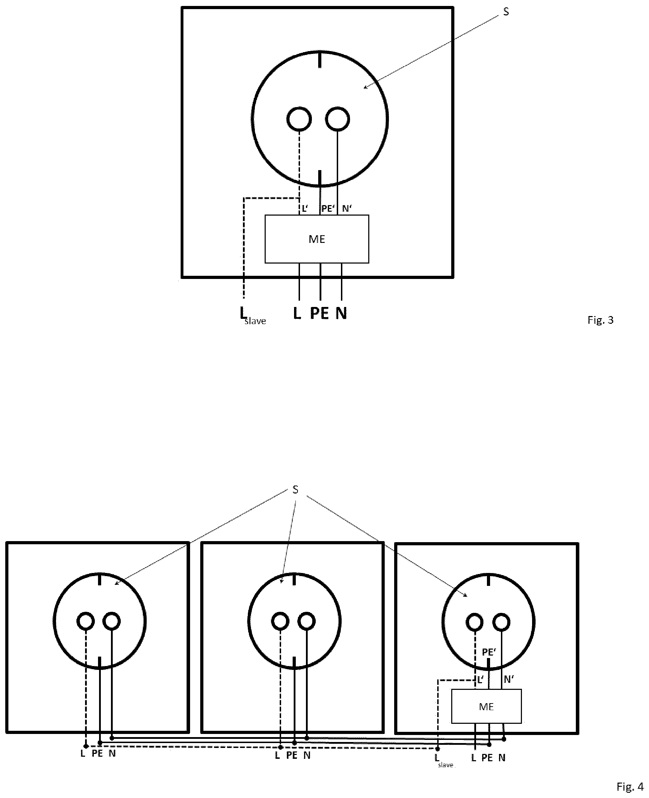

Im Gegensatz dazu ist bei der in Figur 3 gezeigten erfindungsgemäßen messenden Steckdose S, ein Anschlussmittel für einen Außenleiter L vorgesehen, das den Außenleiter L zur Bildung einer Messbrücke Lₛₗₐᵥₑ nach der Energie- und/ oder Leistungsmessungseinrichtung ME kontaktiert. Dieses erlaubt es, dass die Energie- und/ oder Leistungsmessungseinrichtung ME über die Messbrücke Lₛₗₐᵥₑ weitere an die messende Steckdose S angeschlossene Lasten desselben Lastkreises hinsichtlich der Energie- und/oder Leistungsmessung erfassbar macht. In einer (nicht dargestellten) Weiterbildung der erfindungsgemäßen messenden Steckdose S weist diese ein Betätigungselement zur Vor-Ort-Betätigung auf, durch das die Energie- und/oder Leistungsmessungseinrichtung ME und/oder ein Relais gesteuert, insbesondere ein- oder ausgeschaltet, werden kann. Die erfindungsgemäße Steckdose S umfasst zudem eine der Übersichtlichkeit halber nicht dargestellte Sendeeinheit zum Übersenden der durch die Energie- und/oder Leistungsmessung ME erhaltenen Daten an eine Auswerteeinheit, beispielsweise eines Endgerätes.

Dieser Umstand ist in Figur 4 visualisiert, die eine schematische Darstellung einer erfindungsgemäßen messenden Steckdose S zeigt, die über einen Außenleiter L zur Bildung einer Messbrücke Lₛₗₐᵥₑ an zwei weitere nicht messende Steckdosen S desselben Lastkreises angeschlossen ist. Hierdurch wird ein erfindungsgemäßes Netzwerk von elektrischen/elektronischen Installationsgeräten realisiert. Es versteht sich, dass das erfindungsgemäße Netzwerk von elektrischen/elektronischen Installationsgeräten desselben Lastkreises nicht nur, wie dargestellt, messende Steckdosen S, sondern auch andere Lasten, beispielsweise Jalousiemotoren oder Leuchten, umfassen kann.

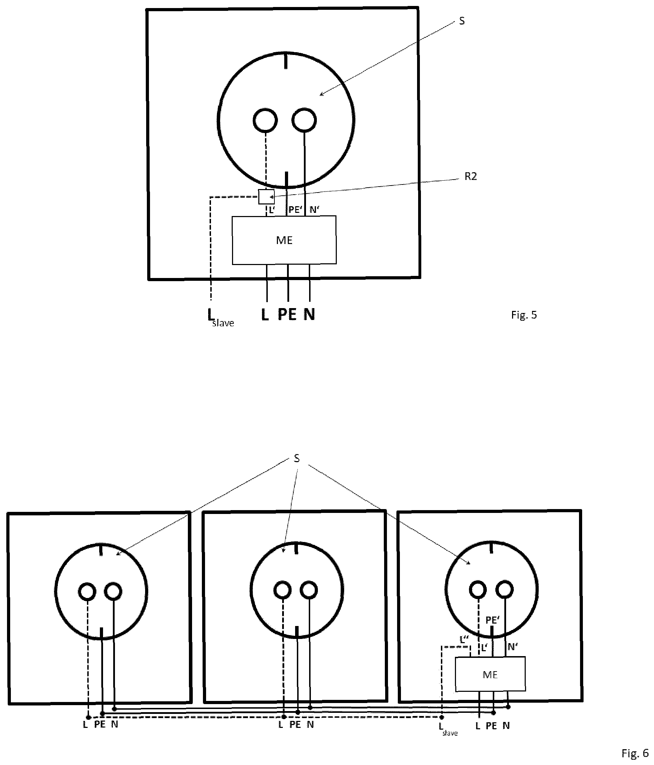

Als besonders bevorzugte Weiterbildung der in Figur 3 gezeigten erfindungsgemäßen messenden Steckdose S zeigt Figur 5 eine schematische Darstellung einer erfindungsgemäßen messenden Steckdose S mit einem zweikanaligen Relais R2. Dieses ist über eine Fernbedienung steuerbar, beispielsweise über ein mobiles Endgerät. Dabei ist ein Schaltelement in den die Messbrücke Lₛₗₐᵥₑ realisierenden Außenleiter L integriert, so dass auch über die Messbrücke Lₛₗₐᵥₑ weitere an die messende Steckdose S angeschlossene Lasten desselben Lastkreises schaltbar gemacht werden. Damit kann auf besonders vorteilhafte Weise nicht nur die Mess- sondern auch die Schaltfunktionalität auf beliebige Lasten desselben Lastkreises ausgeweitet werden.

In Figur 6 ist eine besonders bevorzugte Ausgestaltung der erfindungsgemäßen messenden Steckdose S gezeigt, wobei ist die Energie und/oder- Leistungsmessungseinrichtung ME als mehrkanalige, hier: als zweikanalige, Energie und/oder-Leistungsmessungseinrichtung ME ausgeführt ist. Hierdurch werden auf vorteilhafte Weise weitere an die messende Steckdose S angeschlossenen Lasten desselben Lastkreises hinsichtlich der Energie- und/oder Leistungsmessung getrennt erfassbar gemacht. Damit wird die Auswertung der Energie- und/oder Leistungsmessung weiter individualisiert, ohne weitere messende Steckdosen S vorsehen zu müssen. Hierzu weist die Energie und/oder-Leistungsmessungseinrichtung ME einen weiteren Eingang auf, um die getrennte Energie und/oder-Leistungsmessungseinrichtung ME zu ermöglichen und hierdurch eine individuelle Auswertung der unterschiedlichen Lasten desselben Lastkreises zu ermöglichen.

Die Erfindung ist anhand von Ausführungsbeispielen beschrieben. Ohne den Umfang der geltenden Ansprüche zu verlassen, ergeben sich für einen Fachmann zahlreiche weitere Möglichkeiten, diese umzusetzen, ohne dass dieses im Rahmen dieser Ausführungen im Einzelnen erläutert werden müsste.

### Bezugszeichenliste

- L,L', L": Außenleiter
- Lₛₗₐᵥₑ: Messbrücke
- ME: Energie- und/oder Leistungsmessungseinrichtung
- N, N': Neutralleiter
- PE, PE': Schutzleiter
- R2: zweikanaliges Relais
- S: Steckdose

## Patentansprüche

1. Messende Steckdose zur Energie- und/oder Leistungsmessung bezüglich einer an die Steckdose (S) angeschlossenen Last, umfassend jeweils mindestens zwei Anschlussmittel für einen Außenleiter (L), einen Neutralleiter (N) und einen Schutzleiter (PE), die an einen Außenleiterkontakt, den Neutralleiterkontakt und den Schutzleiterkontakt der Steckdose (S) angeschlossen sind, sowie ferner umfassend eine Energie- und/oder Leistungsmessungseinrichtung (ME), sowie eine Sendeeinheit zum Übersenden der durch die Energie- und/oder Leistungsmessung erhaltenen Daten an eine Auswerteeinheit, **dadurch gekennzeichnet, dass** eines der Anschlussmittel für den Außenleiter (L) dazu ausgebildet ist, den Außenleiter (L) zur Bildung einer Messbrücke (Lₛₗₐᵥₑ) nach der Energie- und/oder Leistungsmessungseinrichtung (ME) zu kontaktieren, so dass die Energie- und/ oder Leistungsmessungseinrichtung (ME) über die Messbrücke (Lₛₗₐᵥₑ) weitere an die messende Steckdose (S) angeschlossene Lasten desselben Lastkreises hinsichtlich der Energie- und/oder Leistungsmessung erfassbar macht, wobei das die Messbrücke (Lₛₗₐᵥₑ) umfassende Anschlussmittel als drittes Anschlussmittel für den Außenleiter (L) ausgeführt ist.

2. Steckdose nach Anspruch 1, **dadurch gekennzeichnet, dass** die Steckdose (S) ein einkanaliges, ein Schaltelement aufweisendes, Relais umfasst, welches über eine Fernbedienung steuerbar ist.

3. Steckdose nach Anspruch 1, **dadurch gekennzeichnet, dass** das die Steckdose ein zweikanaliges, zwei Schaltelemente aufweisendes, Relais (R2) umfasst, welches über eine Fernbedienung steuerbar ist, wobei ein Schaltelement in den die Messbrücke (Lₛₗₐᵥₑ) realisierenden Außenleiter integriert ist, so dass auch über die Messbrücke weitere an die messende Steckdose (S) angeschlossene Lasten desselben Lastkreises schaltbar gemacht werden.

4. Steckdose nach einem der Ansprüche 1 bis 3, **dadurch gekennzeichnet, dass** die Energie- und/oder Leistungsmessungseinrichtung (ME) als mehrkanalige, insbesondere zweikanalige, Energie- und/oder Leistungsmessungseinrichtung (ME) ausgeführt ist, so dass die weiteren an die messende Steckdose (S) angeschlossenen Lasten desselben Lastkreises hinsichtlich der Energie- und/oder Leistungsmessung getrennt erfassbar werden.

5. Steckdose nach einem der Ansprüche 1 bis 4, **dadurch gekennzeichnet, dass** die Anschlussmittel als Steckklemmen ausgeführt sind.

6. Steckdose nach einem der Ansprüche 1 bis 5, **dadurch gekennzeichnet, dass** die Steckdose (S) ein Betätigungselement zur Vor-Ort-Betätigung aufweist, durch das die Energie- und/oder Leistungsmessungseinrichtung (ME) und/oder ein Relais gesteuert, insbesondere ein- oder ausgeschaltet, werden kann.

7. Netzwerk von elektrischen/elektronischen Installationsgeräten umfassend mindestens ein elektrisches/elektronisches Installationsgerät, insbesondere einen Lichtschalter, einen Jalousieschalter oder eine Steckdose, **dadurch gekennzeichnet, dass** das Netzwerk ferner eine messende Steckdose (S) nach einem der Ansprüche 1 bis 6 umfasst, wobei das mindestens eine elektrische/elektronische Installationsgerät und die messende Steckdose (S) an einen Lastkreis angeschlossen und über die Messbrücke (Lₛₗₐᵥₑ) miteinander verbunden sind, so dass die Energie- und/oder Leistungsmessung des Lastkreises ermöglicht wird.

## Claims

1. Measuring socket for measuring energy and/or power in relation to a load connected to the socket (S), comprising at least two connection means each for an outer conductor (L), a neutral conductor (N) and a protective conductor (PE), which are connected to an outer conductor contact, the neutral conductor contact and the protective conductor contact of the socket (S), and further comprising an energy and/or power measuring device (ME) and a transmission unit for transmitting the data obtained through the energy and/or power measurement to an evaluation unit, **characterised in that** one of the connection means for the external conductor (L) is designed to contact the external conductor (L) to form a measuring bridge (Lₛₗₐᵥₑ) behind the energy and/or power measurement device (ME), so that the energy and/or power measurement device (ME) can detect via the measuring bridge (Lₛₗₐᵥₑ) further loads of the same load circuit connected to the measuring socket (S) with regard to energy and/or power measurement, wherein the connection means comprising the measuring bridge (Lₛₗₐᵥₑ) is designed as a third connection means for the outer conductor (L).

2. Socket according to Claim 1, **characterised in that** the socket (S) comprises a single-channel relay with a switching element, which relay can be controlled via remote control.

3. Socket according to Claim 1, **characterised in that** the socket comprises a two-channel relay (R2) with two switching elements, which relay can be controlled via a remote control, wherein one switching element is integrated into the outer conductor implementing the measuring bridge (Lₛₗₐᵥₑ), so that further loads of the same load circuit connected to the measuring socket (S) can be made switchable via the measuring bridge.

4. Socket according to any of Claims 1 to 3, **characterised in that** the energy and/or power measuring device (ME) is designed as a multichannel, in particular two-channel, energy and/or power measuring device (ME), so that the other loads of the same load circuit connected to the measuring socket (S) can be recorded separately with regard to energy and/or power measurement.

5. Socket according to any of Claims 1 to 4, **characterised in that** the connection means are designed as plug-in terminals.

6. Socket according to any of Claims 1 to 5, **characterised in that** the socket (S) has an actuating element for local actuation, by means of which the energy and/or power measuring device (ME) and/or a relay can be controlled, in particular switched on or off.

7. Network of electrical/electronic installation devices comprising at least one electrical/electronic installation device, in particular a light switch, a blind switch or a socket, **characterised in that** the network further comprises a measuring socket (S) according to any of claims 1 to 6, wherein the at least one electrical/electronic installation device and the measuring socket (S) are connected to a load circuit and are interconnected via the measuring bridge (Lₛₗₐᵥₑ) so that the energy and/or power of the load circuit can be measured.

## Revendications

1. Prise de mesure pour mesurer l'énergie et/ou la puissance relative à une charge connectée à la prise (S), comprenant au moins deux moyens de connexion chacun pour un conducteur extérieur (L), un conducteur neutre (N) et un conducteur de protection (PE), qui sont raccordés à un contact de conducteur extérieur, au contact de conducteur neutre et au contact de conducteur de protection de la prise (S), et comprenant en outre un dispositif de mesure d'énergie et/ou de puissance (ME), ainsi qu'une unité d'émission pour transmettre les données obtenues par la mesure d'énergie et/ou de puissance à une unité d'évaluation, **caractérisé en ce que** l'un des moyens de raccordement pour le conducteur extérieur (L) est conçu pour contacter le conducteur extérieur (L) afin de former un pont de mesure (Lₛₗₐᵥₑ) derrière le dispositif de mesure d'énergie et/ou de puissance (ME), de sorte que le dispositif de mesure d'énergie et/ou de puissance (ME) peut rendre détectable en termes de mesure d'énergie et/ou de puissance d'autres charges du même circuit de charge raccordées à la prise de mesure (S) via le pont de mesure (Lₛₗₐᵥₑ), le moyen de raccordement comprenant le pont de mesure (Lₛₗₐᵥₑ) étant conçu comme un troisième moyen de raccordement pour le conducteur extérieur (L).

2. Prise selon la revendication 1, **caractérisée en ce que** la prise (S) comprend un relais à canal unique comportant un élément de commutation, ledit relais pouvant être commandé à distance.

3. Prise selon la revendication 1, **caractérisée en ce que** la prise comprend un relais à deux canaux (R2) comportant deux éléments de commutation, ledit relais peut être commandé à distance, un élément de commutation étant intégré dans le conducteur extérieur réalisant le pont de mesure (Lₛₗₐᵥₑ), de sorte que d'autres charges du même circuit de charge raccordées à la prise de mesure (S) peuvent également être commutées via le pont de mesure.

4. Prise selon l'une des revendications 1 à 3, **caractérisé en ce que** le dispositif de mesure d'énergie et/ou de puissance (ME) est conçu comme un dispositif de mesure d'énergie et/ou de puissance multicanaux, en particulier à deux canaux, de sorte que les autres charges du même circuit de charge raccordées à la prise de mesure (S) peuvent être enregistrées séparément en ce qui concerne la mesure d'énergie et/ou de puissance.

5. Prise selon l'une des revendications 1 à 4, **caractérisé en ce que** les moyens de raccordement sont réalisés sous forme de bornes enfichables.

6. Prise selon l'une des revendications 1 à 5, **caractérisé en ce que** la prise (S) comporte un élément d'actionnement pour une action sur place, grâce auquel le dispositif de mesure d'énergie et /ou de puissance (ME) et/ou un relais peuvent être commandés, en particulier activés ou désactivés.

7. Réseau d'appareils d'installation électriques/électroniques comprenant au moins un appareil d'installation électrique/électronique, en particulier un interrupteur d'éclairage, un interrupteur de store ou une prise de courant, **caractérisé en ce que** le réseau comprend en outre une prise de mesure (S) selon l'une des revendications 1 à 6, le au moins un appareil d'installation électrique/électronique et la prise de mesure (S) étant raccordés à un circuit de charge et reliés entre eux par le pont de mesure (Lₛₗₐᵥₑ), de manière à permettre la mesure de l'énergie et/ou de la puissance du circuit de charge.
